# EUROPÄISCHE PATENTANMELDUNG

(11) **EP 1 962 570 A1**
(43) Veröffentlichungstag der Anmeldung: **27.08.2008**
(21) Anmeldenummer: 07003866.6
(22) Anmeldetag: 26.02.2007
(51) Int. Cl.: H05K 7/20

(54) **Elektrisches Gerät und Kühlverfahren für ein elektrisches Gerät**

(71) Anmelder: SIEMENS AKTIENGESELLSCHAFT, 80333 München (DE)
(72) Erfinder: Kaser, Josef, 92263 Ebermannsdorf (DE); Reichenbach, Norbert, 92224 Amberg (DE); Streich, Bernhard, 92224 Amberg (DE); Weigand, Michael, 91154 Roth (DE)

(57) **Zusammenfassung**

Die Erfindung betrifft ein elektrisches Gerät (10) mit einem Gehäuse (12) und mit mindestens einem vom Gehäuse (12) umhüllten Bauelement (21), wobei an der Oberfläche (12A) des Gehäuses (12) Kühlrippen (13) angebracht sind. Außerdem ist ein unabhängiger Verfahrensanspruch vorhanden.

## Beschreibung

Verlustwärme von elektrischen Geräten ist manchmal ein großes Problem, insbesondere für das Gerät selbst und dessen Bauelemente. Zu hohe Temperaturen können zu Funktionsstörungen, zur Beschädigung des Gerätes und sogar zu Bränden führen.

Es ist die erste Aufgabe der Erfindung, ein elektrisches Gerät zu kreieren, das sich von der Verlustwärme auf eine befriedigende Weise befreien kann. Die zweite Aufgabe der Erfindung ist, die bekannten Kühlverfahren für elektrische Geräte zu verbessern.

Diese Aufgaben können mit einem elektrischen Gerät nach Anspruch 1 bzw. mit einem Kühlverfahren nach Anspruch 13 gelöst werden.

Die unter- bzw. nebengeordneten Ansprüche beschreiben verschiedene vorteilhafte Aspekte der Erfindung.

Wenn an der Oberfläche des Gehäuses eines elektrischen Gerätes mit einem Gehäuse und mit mindestens einem vom Gehäuse umhüllten Bauelement Kühlrippen angebracht sind, kann das Gerät besser gekühlt werden, da die Kühlrippen die Oberfläche des Gehäuses vergrößern. Besonders vorteilhaft ist dies, wenn das Bauteil ein Halbleiterbauteil ist, da in Halbleiterbauteilen die Verlustwärmeproduktion relativ hoch sein kann.

Wenn das Gerät mindestens eine Kühlplatte aufweist, die zwischen dem Bauelement und dem Gehäuse befestigt ist, kann Wärme geleitet und daher effektiver zum Gehäuse transportiert werden, insbesondere, wenn das Bauelement an der Kühlplatte befestigt ist, und/oder wenn die Kühlplatte an der Innenseite des Gehäuses befestigt ist.

Die Kühlwirkung kann weiter verbessert werden, wenn die Kühlrippen an der des Bauelementes gegenüber liegende Seite des Gehäuses angebracht sind.

Wenn die Kühlrippen derart gruppiert sind, dass sie einen oder mehrere Durchgänge in eine erste Richtung frei lassen, kann Wärmeübertragung durch Konvektion an den Kühlrippen verbessert werden, da das Kühlmedium bzw. Kühlfluid besser mit den Kühlrippen in Berührung kommt.

Wenn die Gruppierung der Kühlrippen einen Durchgang oder mehrere Durchgänge auch in eine zweite Richtung frei lassen, ist die Konvektion bei einem Gerät, das gerade oder seitlich montiert werden kann, in beiden Stellungen möglich. Das ist insbesondere bei der Wandbefestigung des Gerätes ein großer Vorteil, da dies eine flexiblere Verkabelung des Gerätes ermöglicht.

Wenn die Kühlrippen flügelartig sind, kann die Konvektion verbessert werden.

Wenn das elektrische Gerät ein mehrphasiges Schaltgerät ist mit mindestens einem Stromeingang-Stromausgang -Paar, und wenn das elektrische Gerät ausgebildet ist, das mindestens eine Stromeingang-Stromausgang -Paar voneinander zu trennen und/oder miteinander zu verbinden, kann nebst Verlustwärme eventuell auch schaltbedingte Wärme besser vom Gerät abgeleitet werden. Beispiele von der Letzteren sind die von einem Schaltlichtbogen und von einem Kurzschluss verursachten Wärmeerscheinungen.

Wenn das Bauteil ein Leistungsteil ist, der ausgebildet ist, den Schaltzustand des mindestens einen Stromeingang-Stromausgang -Paares zu ändern oder zu steuern, ist es möglich, auch steuerungsbedingte Wärmeerscheinungen vom Gerät abzuleiten. Dieses ist besonders wichtig, wenn das elektrische Gerät ein Motorstartgerät, beispielsweise ein Sanftstarter zum sanften Starten und/oder Stoppen eines Elektromotors, ist, weil durch einer Ventilansteuerung relativ hohe Verlustwärme entstehen kann.

Nach einer der Erfindung zugrunde liegenden Entdeckung kann die Kühlwirkung eines elektrischen Gerätes mit einem Gehäuse verbessert werden, wenn die Kühlwirkung vorwiegend durch Konvektion des Kühlfluids, bevorzugt Luft, außerhalb des Gehäuses an der Oberfläche des Gehäuses angebrachten Kühlrippen erzielt wird.

Bei der Wandmontage kann die Kühlwirkung noch verbessert werden, wenn ein Teil der Konvektion zwischen den Kühlrippen in einem Durchgang oder in mehreren Durchgängen erzielt wird.

Es zeigen:

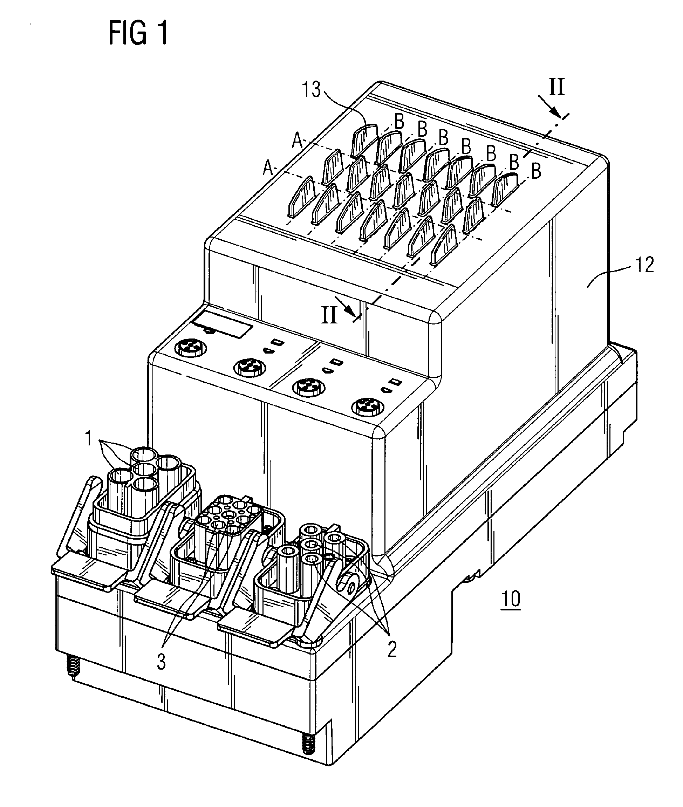

- FIG 1: ein Motorstartgerät in Perspektiv;
- FIG 2: ein Schnitt des in FIG 1 dargestellten Motorstartgerätes in Richtung I-I; und
- FIG 3: das Motorstartgerät von unten.

Das mehrphasige Motorstartgerät 10 hat Stromeingänge 1 für die Stromphasen und entsprechende Stromausgänge 3 für einen elektrischen Verbraucher, wie z.B. einen Elektromotor. Ein weiteres Motorstartgerät kann durch den Durchgangsanschluss 2 mit Strom versorgt werden.

Flügelartige Kühlrippen 13 sind am Gehäuse 12 auf dessen Oberfläche 12A gebracht. Die Kühlrippen 13 sind derart gruppiert, dass sie die Durchgänge A in Querrichtung und die Durchgänge B in Längsrichtung frei lassen.

Die Anzahl der Durchgänge A, B kann variiert werden. Vorteilhaft sind jedoch mindestens drei Durchgänge in beide Richtungen.

Bei der Wandmontage des Motorstartgerätes 10 kommen die Stromeingänge 1 sowie Stromausgänge 3 seitlich oder unterhalb des mit Kühlrippen geflügelten Bereiches.

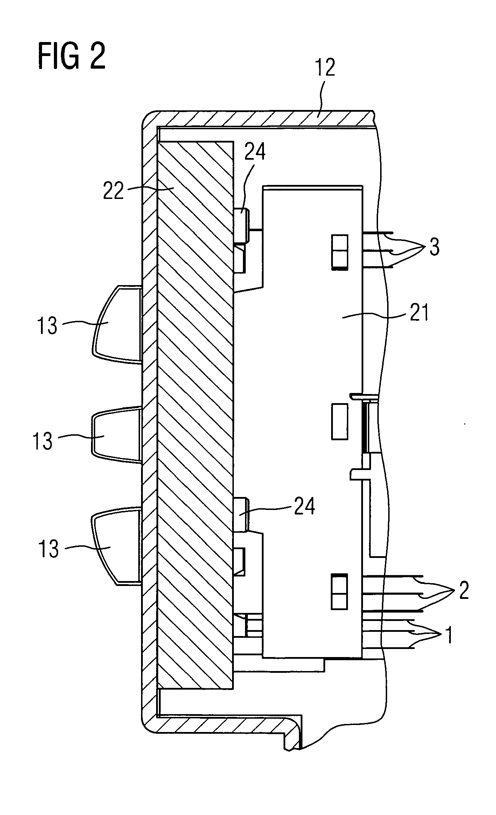

Wie in FIG 2 dargestellt, sind die Kühlrippen 13 im Gehäuse 12 des Motorstartgerätes 10 integriert. Das Gehäuse 12 kann aus Kunststoff bestehen, vorzugsweise aus UL-gelistetem Material. Das Gehäuse 12 wird bevorzugt mit einem Spritzverfahren gefertigt mit den integrierten Kühlrippen.

Der Leistungsteil 21 kann den Schaltzustand der Stromeingänge 1 und der respektiven Stromausgänge 3 ändern oder steuern. Insbesondere ist der Leistungsteil 21 ausgebildet, die Ventilansteuerung der Stromausgänge 2 auszuführen.

Der Leistungsteil 21 wird an einer Kühlplatte 22 befestigt, die dann an dem Gehäuse 12 auf der Innenseite 12B befestigt wird.

Um die Wärmeübertragung zu optimieren, wird zwischen dem Leistungsteil 21 und der Kühlplatte 22 und zwischen der Kühlplatte 22 und dem Gehäuse 12 eine Wärmeleitpaste oder Wärmeleitfolie verwendet.

Die Kühlplatte 22 kann zu dem Gehäuse 12 beispielsweise durch Schrauben 24 befestigt werden. In FIG 2 ist nur eine Kante der Schraube 24 gezeigt.

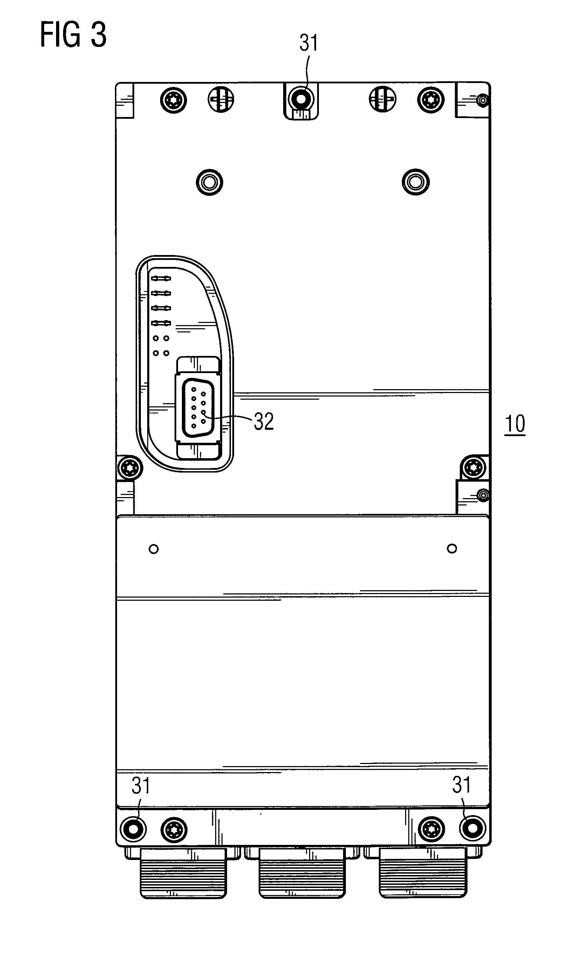

FIG 3 zeigt eine Ansicht des Motorstartgerätes 10 von unten. Das Motorstartgerät 10 weist Wandbefestigungsmittel auf, beispielsweise Schrauben 31 oder eine Aufnahmevertiefung für eine Montageschiene.

Das Motorstartgerät 10 kann durch eine Kommunikationsschnittstelle, wie beispielsweise die serielle Schnittstelle 32, z.B. RS-232, gesteuert werden.

Durch die dargestellte Ausführungsform kann mit einem Motorstartgerät mit Halbleiterteil als Leistungsteil die Wärmeabfuhr von der Vorgängerkonstruktion, die als Gemeinschaftsgeschmacksmuster Nr. 000527841 eingetragen wurde, um 1 W erhöht werden.

## Patentansprüche

1. Elektrisches Gerät (10) mit einem Gehäuse (12) und mit mindestens einem vom Gehäuse (12) umhüllten Bauelement (21), wobei an der Oberfläche (12A) des Gehäuses (12) Kühlrippen (13) angebracht sind.

2. Elektrisches Gerät (10) nach Anspruch 1, wobei das Gerät (10) mindestens eine Kühlplatte (22) aufweist, die zwischen dem Bauelement (21) und dem Gehäuse (12) befestigt ist.

3. Elektrisches Gerät (10) nach Anspruch 2, wobei das Bauelement (21) an der Kühlplatte (22) befestigt ist.

4. Elektrisches Gerät (10) nach Anspruch 2 oder 3, wobei die Kühlplatte (22) an der Innenseite (12B) des Gehäuses (12) befestigt ist.

5. Elektrisches Gerät (10) nach einem der Ansprüche 2 bis 4, wobei die Kühlrippen (13) an der des Bauelementes (21) gegenüberliegende Seite des Gehäuses (12) angebracht sind.

6. Elektrisches Gerät (10) nach einem der vorhergehenden Ansprüche, wobei die Kühlrippen (13) derart gruppiert sind, dass sie einen oder mehrere Durchgänge (A) in eine erste Richtung frei lassen.

7. Elektrisches Gerät (10) nach Anspruch 6, wobei die Gruppierung der Kühlrippen (13) einen oder mehrere Durchgänge (B) auch in eine zweite Richtung frei lassen.

8. Elektrisches Gerät (10) nach einem der vorhergehenden Ansprüche, wobei die Kühlrippen (13) flügelartig sind.

9. Elektrisches Gerät (10) nach einem der vorhergehenden Ansprüche, wobei das Bauteil (21) ein Halbleiterbauteil ist.

10. Elektrisches Gerät (10) nach einem der vorhergehenden Ansprüche, wobei das elektrische Gerät (10) ein mehrphasiges Schaltgerät ist und mindestens ein Stromeingang (1)-Stromausgang (3) -Paar aufweist, wobei das elektrische Gerät (10) ausgebildet ist, das mindestens eine Stromeingang (1)-Stromausgang (3) -Paar voneinander zu trennen und/oder miteinander zu verbinden.

11. Elektrisches Gerät (10) nach Anspruch 10, wobei das Bauteil (12) ein Leistungsteil ist, der ausgebildet ist, den Schaltzustand des mindestens einen Stromeingang (1)-Stromausgang (3) -Paares zu ändern oder zu steuern.

12. Elektrisches Gerät (10) nach Anspruch 10 oder 11, wobei das elektrische Gerät (10) ein Motorstartgerät, beispielsweise ein Sanftstarter zum sanften Starten und/oder Stoppen eines Elektromotors ist.

13. Kühlverfahren für ein elektrisches Gerät (10) mit einem Gehäuse (12), wobei die Kühlwirkung vorwiegend durch Konvektion des Kühlfluides, bevorzugt Luft, außerhalb des Gehäuses (12) an der Oberfläche (12A) des Gehäuses (12) gebrachten Kühlrippen (13) erzielt wird.

14. Kühlverfahren nach Anspruch 13, wobei ein Teil der Konvektion zwischen den Kühlrippen (13) in einem Durchgang oder in mehreren Durchgängen (A/B) erzielt wird.

15. Kühlverfahren nach Anspruch 13 oder 14, wobei die Konvektion bei einem an die Wand befestigten elektrischen Gerät (10) an einer der Wand parallelen Seite des Gerätes (10) erzielt wird.

## Geänderte Patentansprüche

### Geänderte Patentansprüche gemäss Regel 137(2) EPÜ.

**1.** Elektrisches Gerät (10) mit einem Gehäuse (12) und mit mindestens einem vom Gehäuse (12) umhüllten Bauelement (21), wobei an der Oberfläche (12A) des Gehäuses (12) Kühlrippen (13) angebracht sind, die derart gruppiert sind, dass sie einen oder mehrere Durchgänge (A, B) jeweils in eine erste Richtung und auch in eine zweite Richtung frei lassen.

**2.** Elektrisches Gerät (10) nach Anspruch 1, wobei das Gerät (10) mindestens eine Kühlplatte (22) aufweist, die zwischen dem Bauelement (21) und dem Gehäuse (12) befestigt ist.

**3.** Elektrisches Gerät (10) nach Anspruch 2, wobei das Bauelement (21) an der Kühlplatte (22) befestigt ist.

**4.** Elektrisches Gerät (10) nach Anspruch 2 oder 3, wobei die Kühlplatte (22) an der Innenseite (12B) des Gehäuses (12) befestigt ist.

**5.** Elektrisches Gerät (10) nach einem der Ansprüche 2 bis 4, wobei die Kühlrippen (13) an der des Bauelementes (21) gegenüberliegende Seite des Gehäuses (12) angebracht sind.

**6.** Elektrisches Gerät (10) nach einem der vorhergehenden Ansprüche, wobei die Kühlrippen (13) flügelartig sind.

**7.** Elektrisches Gerät (10) nach einem der vorhergehenden Ansprüche, wobei das Bauteil (21) ein Halbleiterbauteil ist.

**8.** Elektrisches Gerät (10) nach einem der vorhergehenden Ansprüche, wobei das elektrische Gerät (10) ein mehrphasiges Schaltgerät ist und mindestens ein Stromeingang (1)-Stromausgang (3) -Paar aufweist, wobei das elektrische Gerät (10) ausgebildet ist, das mindestens eine Stromeingang (1)-Stromausgang (3) -Paar voneinander zu trennen und/oder miteinander zu verbinden.

**9.** Elektrisches Gerät (10) nach Anspruch 8, wobei das Bauteil (12) ein Leistungsteil ist, der ausgebildet ist, den Schaltzustand des mindestens einen Stromeingang (1)-Stromausgang (3) -Paares zu ändern oder zu steuern.

**10.** Elektrisches Gerät (10) nach Anspruch 8 oder 9, wobei das elektrische Gerät (10) ein Motorstartgerät, beispielsweise ein Sanftstarter zum sanften Starten und/oder Stoppen eines Elektromotors ist.

**11.** Kühlverfahren für ein elektrisches Gerät (10) mit einem Gehäuse (12), wobei die Kühlwirkung vorwiegend durch Konvektion des Kühlfluides, bevorzugt Luft, außerhalb des Gehäuses (12) an der Oberfläche (12A) des Gehäuses (12) gebrachten Kühlrippen (13) erzielt wird, indem ein Teil der Konvektion zwischen den Kühlrippen (13) in einem oder mehreren Durchgängen (A, B) jeweils in eine erste Richtung und auch in eine zweite Richtung erzielt wird.

**12.** Kühlverfahren nach Anspruch 11, wobei die Konvektion bei einem an die Wand befestigten elektrischen Gerät (10) an einer der Wand parallelen Seite des Gerätes (10) erzielt wird.
